# EUROPÄISCHE PATENTSCHRIFT

(11) **EP 2 871 763 B1**
(45) Veröffentlichungstag und Bekanntmachung des Hinweises auf die Patenterteilung: **16.08.2017**
(21) Anmeldenummer: 14186234.2
(22) Anmeldetag: 24.09.2014
(51) Int. Cl.: H02M 7/48, H03K 17/689, H03K 17/687

(54) **Ansteuersystem zur Ansteuerung von Brückenschaltungen mit symmetrisch geerdetem Zwischenkreis**
Control system for driving bridge circuits with a symmetrically grounded intermediate circuit
Système de commande de circuits en pont doté de circuit intermédiaire mis à la terre symétriquement

(30) Priorität: 07.11.2013 DE 102013112264
(43) Veröffentlichungstag der Anmeldung: 13.05.2015
(73) Patentinhaber: SEMIKRON Elektronik GmbH & Co. KG, 90431 Nürnberg (DE)
(72) Erfinder: Herzer, Reinhard, 98693 Ilmenau (DE); Vogler, Bastian, 90763 Fürth (DE)

(56) Entgegenhaltungen:
- WO-A1-2013/007788
- US-A1- 2003 112 040
- US-A1- 2006 050 455

## Beschreibung

Die Erfindung beschreibt ein Ansteuersystem mit integrierbaren Komponenten, wie einer Ansteuerschaltung, mit mehreren Übertragungsstufen zur Übertragung von Eingangssignalen von einer übergeordneten Steuerung mit einem ersten Bezugspotential hin zu Treiberstufen zur direkten Ansteuerung von Halbleiterschaltern mit jeweils unterschiedlichen Bezugspotentialen, wobei die Halbleiterschalter Halbbrückenschaltungen mit symmetrisch geerdetem Zwischenkreis ausbilden. Brückenschaltungen sind allgemein als Ein-, Zwei-, oder Dreiphasen-Brückenschaltungen, fachüblich ausgeführt als Leistungshalbleitermodule, bekannt. Hierbei bildet die einphasige Halbbrückenschaltung den Grundbaustein einer Vielzahl von leistungselektronischen Schaltungen aus. In einer Ausgestaltung einer Halbbrückenschaltung sind zwei Halbleiterschalter, ein erster unterer sog. BOT-Halbleiterschalter, auch als Low-Side-Schalter bekannt, und ein zweiter oberer sog. TOP- Halbleiterschalter, auch als High-Side-Schalter bekannt, in einer Reihenschaltung angeordnet. Eine derartige Halbbrückenschaltung weist fachüblich eine Verbindung zu einem Gleichspannungszwischenkreis auf. Der Ausgang der Halbbrückenschaltung ist als Wechselspannungsanschluss ausgebildet und mit einer Last verbunden.

Durch das alternierende Schalten von TOP- und BOT-Halbleiterschalter variiert die Ausgangsspannung der Halbbrücke zwischen den festen Spannungswerten des positiven und negativen Spannungsanschlusses des Zwischenkreises und damit auch der Halbbrücke selbst. Da somit zwei stationäre Spannungszustände existieren, wird eine derartige Halbbrückenschaltung auch als Zwei-Level-Inverter bezeichnet.

Fachübliche Ausgestaltungen des Gleichspannungszwischenkreises sind diejenigen mit symmetrischer Erdung und diejenigen mit asymmetrische Erdung. Bei symmetrischer Erdung weist der Gleichspannungszwischenkreis zwei in Reihe geschaltete gleiche Teilzwischenkreise auf, die aus dem positiven und dem negativem Spannungsanschluss gespeist werden. Die gemeinsame Verbindung in der Mitte der beiden Teilzwischenkreise wird als Neutralknoten bezeichnet und ist fachüblich geerdet. Bei der asymmetrischen Ausgestaltung ist fachüblich der negativen Spannungsanschluss geerdet.

Allgemein bekannt sind auch komplexere Halbbrückenschaltungen, bei denen drei oder mehr stationäre Spannungszustände schaltbar sind. Diese bezeichnet man als Multi-Level-Inverter. Der Vorteil von Multi-Level-Invertern ist, dass der Verlauf der Ausgangsspannung näher dem gewünschten sinusförmigen Verlauf angenähert werden kann. Dadurch kann die gesamte harmonische Verzerrung (Total Harmonic Distortion, THD) reduziert werden, wodurch kleinere und kostengünstigere Netzfilter eingesetzt werden können. Andererseits können mittels Multi-Level-Invertern gegenüber Zwei-Level-Invertern gleiche Werte der THD mit niedrigerer Schaltfrequenz erreicht werden, wodurch geringere Schaltverluste entstehen. Nachteilig bei Multi-Level-Invertern sind allerdings der erhöhte Aufwand für die Regelung sowie die höhere Anzahl an notwendigen Bauelementen und Ansteuerschaltungen.

Die einfachste Ausgestaltung eines Multi-Level-Inverters ist der Drei-Level-Inverter mit genau drei schaltbaren Spannungszuständen. Grundsätzlich sind zwei Topologien, nämlich die NPC (Neutral Point Clamp) und die TNPC (T-type Neutral Point Clamp) Topologie für Drei-Level-Inverter bekannt, bei denen die Speisung mit symmetrischer Erdung von Teilzwischenkreisen am Neutralknoten gemeinsam ist, wobei der Neutralknoten als dritter Spannungszustand genutzt wird.

Ansteuersysteme für Leistungsbrückenschaltungen bestehen fachüblich aus mehreren Teilschaltungen bzw. Funktionsblöcken. Das Steuersignal einer übergeordneten Steuerschaltung wird in einer ersten Teilschaltung, der Ansteuerlogik, aufbereitet und über weitere Komponenten der jeweiligen Treiberstufe zugeführt. Die sekundärseitigen Treiberstufen steuern die Halbleiterschalter entsprechend der übertragenen Ansteuersignale an.

Bei höheren Zwischenkreisspannungen, in der Regel größer 40V, erfolgt fachüblich eine Potentialtrennung der primärseitigen Schaltungsteile von den sekundärseitigen, da sich die jeweiligen Schaltungsteile auf unterschiedlichem Bezugspotential befinden. Hierbei finden zur galvanischen Trennung fachüblich Impulsübertrager, Optokoppler oder Lichtwellenleiter Verwendung.

Fachüblich, bespielhaft offenbart in der DE 10 2010 018 997 A1, werden bei Ansteuerschaltungen Hochspannungsschaltkreise (HVIC - High Voltage Integrated Circuit) eingesetzt. HVICs bieten die Möglichkeit, eine Potentialtrennung zwischen dem primärseitigen und dem sekundärseitigen Schaltungsteil der Ansteuerschaltung zu realisieren, und können weiterhin ein Hochspannungsbauelement, üblicherweise einen lateraler Hochspannungs- MOSFET, aufweisen, welcher zur Signalübertragung zwischen dem primärseitigen und dem sekundärseitigen Schaltungsteil, in sog. Levelshiftern eingesetzt wird. Eine Alternative offenbart die DE 10 2005 043 907 A1 bei der ein zu übertragendes Ansteuersignal über eine kapazitive Übertragungsstrecke von einem primärseiteigen Schaltungsteil zu einem sekundärseitigen Schaltungsteil übertragen wird.

Es ist bekannt und vorteilhaft die Levelshifter als Teil der Ansteuerschaltung im HVIC integriert auszuführen. Es sind zwei grundlegende Isolationstechnologien zur Ausbildung von HVICs bekannt. Einerseits die SOI (Silicon on Insulator) - Technologien und andererseits pn- isolierte Technologien (Junction Isolation). Die SOI- Technologie bietet eine dielektrische Potentialtrennung von Bauelementen oder Bauelementgruppen, steht aber derzeit auf Grund der begrenzten Spannungsfestigkeit nur bis 800V Potentialdifferenz zur Verfügung. Bei pn- isolierten Technologien wird die Potentialdifferenz von einem sperrgepolten pn- Übergang aufgenommen. Diese Technik steht derzeit bis 1200V Potentialdifferenz zur Verfügung.

Grundsätzlich sind verschiedene monolithisch integrierte Levelshiftertopologien bekannt. Eine einfache Topologie, besteht aus einem Hochspannungs- Transistor (HV-Transistor) mit entsprechender Sperrfähigkeit und einem Widerstand in Reihenschaltung. Wird auf einer ersten Seite ein Signal auf das Gate des HV-Transistors gegeben, schaltet dieser ein. Der dadurch erzeugte Querstrom durch den Levelshifter verursacht einen Spannungsabfall über dem Widerstand, der als Signal von einer Auswerteschaltung auf einer zweiten Seite erfasst werden kann. Derartige Levelshifter mit HV-Transistoren enthalten Prinzip bedingt einen zur Signalübertragung notwendigen Querstrompfad, so dass eine Potentialtrennung aber keine galvanische Trennung vorliegt.

In der DE 101 52 930 A1 wird eine erweiterte Levelshiftertopologie offenbart, bei der das Ansteuersignal schrittweise, mittels einer Mehrzahl gleichartiger, kaskadiert geschalteter Levelshifter, über Zwischenpotentiale übertragen wird. Damit sind Transistoren einsetzbar, die nur den Bruchteil der geforderten Sperrfähigkeit des gesamten Levelshifters besitzen. Somit kann die Sperrfähigkeit des Levelshifters wesentlich erhöht werden.

Die DE 10 2006 037 336 offenbart einen Levelshifter ausgeführt als eine Reihenschaltung von HV-Transistoren vom n-Kanal-Typ. Diese Topologie weist die Vorteile auf, dass gegenüber derjenigen gemäß DE 101 52 930 A1 zum einen der Leistungsverbrauch und zum anderen der Schaltungsaufwand verringert sind. Dies hat insbesondere einen geringeren Platzbedarf zur Folge.

Allen genannten Ausgestaltungen für HVICs ist gemein, dass bei komplementärem Aufbau des Levelshifters auch eine Signalübertragung von einem Schaltungsteil mit einem hohen Bezugspotential zu einem Schaltungsteil mit einem niedrigen Bezugspotential grundsätzlich möglich ist. Diese Eigenschaft kann somit für eine Signalrückübertragung von der zweiten Seite zur ersten Seite genutzt werden. Voraussetzung hierfür ist allerdings ein HV- Transistor vom p-Kanal-Typ.

Durch parasitäre Induktivitäten eines Systems aus einem Leistungshalbleitermodul und einer Ansteuerschaltung kann es während schnellen Schaltens der Halbleiterschalter zu einem starken Verriss des jeweiligen Bezugspotentials der sekundärseitigen Schaltungsteile meist in positiver aber auch in negativer Richtung und damit unter das primärseitige Bezugspotential kommen. Dies tritt in besonders starkem Maße in Systemen mittlerer und hoher Leistung auf, bei denen große Ströme, insbesondere größer 50A, geschaltet werden. Die meisten, heute verfügbaren Levelshifter sind allerdings nicht für eine derartige Signalübertragung in negativer Richtung ausgelegt. Auch weisen die bekannten pn-Isolationstechnologien den Nachteil auf, dass bei einem entsprechenden Verriss des Bezugspotentials in negative Richtung die Sperrfähigkeit zwischen dem primär- und dem sekundärseitigen Schaltungsteil verloren geht und der fließende Leckstrom zum Zünden parasitärer Thyristorstrukturen, dem sog. Latch-up, führen kann. Dies führt zum Funktionsverlust und eventuell zur Zerstörung der betroffenen Schaltungen.

Eine derartige Einschränkung ist, bedingt durch die dielektrische Isolation und die damit verbundene bidirektionale Sperrfähigkeit der Isolationsgebiete, bei SOI-Technologien nicht gegeben, so dass Übertragungsschaltungen umsetzbar sind, die auch bei kurzzeitig oder dauerhaft negativem sekundärseitigem Bezugspotential eine sichere Signalübertragung und Isolation gewährleisten. Die DE 10 2006 050 913 A1 offenbart einen derartigen Levelshifter für eine BOT- Sekundärseite ausgeführt in SOI-Technologie mit jeweils einem UP- und DOWN- Levelshifterzweig, während die DE 10 2007 006 319 A1 einen derartigen Levelshifter für eine TOP-Sekundärseite ebenso in SOI- Technologie ausgeführt als UP- und DOWN- Levelshifterzweig offenbart.

Weiterhin zählt die US 2006/0050455 A1 zum Stand der Technik. Diese offenbart ein Ansteuersystem für eine Halbbrückenschaltung mit einer übergeordneten Steuerung, einer Schnittstellenschaltung und einer Ansteuerschaltung mit einem primärseitigen Schaltungsteil, einer Ansteuerlogik mit einem primärseitigen Bezugspotential und sekundärseitigen Schaltungsteilen jeweils mit einer Treiberstufe ausgebildet zur Ansteuerung einer Halbbrückenschaltung mit, einem negativen und einem positiven Spannungsanschluss, einer Mehrzahl von Halbleiterschaltern, wobei jeder Halbleiterschalter und die ihm zugeordnete Treiberstufe ein zugeordnetes sekundärseitiges Bezugspotential aufweist, wobei jeweils ein Ansteuer-Levelshifter den primärseitigen Schaltungsteil mit dem jeweiligen sekundärseitigen Schaltungsteil verbindet und somit jeweils beiden Schaltungsteilen zugeordnet ist, wobei Schnittstellen-Levelshifter die Schnittstellenschaltung mit der Ansteuerlogik der Ansteuerschaltung verbinden und wobei die Schnittstellenschaltung, die Schnittstellen-Levelshifter, die Ansteuerlogik ein unterer Ansteuer-Levelshifter sowie die damit verbundene untere Treiberstufe in einem HVIC monolithisch integriert sind.

Der Erfindung liegt die Aufgabe zugrunde ein Ansteuersystem mit monolithisch integrierbaren Komponenten zur Ansteuerschaltung von Brückenschaltungen mit symmetrisch geerdetem Zwischenkreis vorzustellen.

Diese Aufgabe wird erfindungsgemäß gelöst durch eine Ansteuerschaltung mit den Merkmalen des Anspruchs 1. Bevorzugte Ausführungsformen sind in den abhängigen Ansprüchen beschrieben.

Die Erfindung beschreibt ein Ansteuersystem für eine Halbbrückenschaltung mit einer übergeordneten Steuerung, einer Schnittstellenschaltung und einer Ansteuerschaltung mit einem primärseitigen Schaltungsteil, einer Ansteuerlogik mit einem primärseitigen Bezugspotential und sekundärseitigen Schaltungsteilen, jeweils mit einer Treiberstufe ausgebildet zur Ansteuerung einer Halbbrückenschaltung mit einem symmetrisch an einem Neutralpunkt geerdeten Zwischenkreis, mit einem negativen und einem positiven Spannungsanschluss, einer Mehrzahl von Halbleiterschaltern, wobei jeder Halbleiterschalter und die ihm zugeordnete Treiberstufe ein zugeordnetes sekundärseitiges Bezugspotential aufweist. Hierbei verbindet jeweils ein Ansteuer-Levelshifter den primärseitigen Schaltungsteil mit dem jeweiligen sekundärseitigen Schaltungsteil, wodurch der jeweilige Ansteuer-Levelshifter beiden Schaltungsteilen zugeordnet ist. Das primärseitige Bezugspotential und ein unteres sekundärseitiges Bezugspotential einer unteren Treiberstufe entsprechen dem Potential des negativen Spannungsanschlusses. Schnittstellen-Levelshifter verbinden die Schnittstellenschaltung mit der Ansteuerlogik der Ansteuerschaltung. Die übergeordnete Steuerung und die Schnittstellenschaltung liegen auf dem Potential des Neutralpunkts.

Der untere Ansteuer-Levelshifter überträgt hierbei Ansteuersignale der Ansteuerlogik zur unteren Treiberstufe, die wiederum den unteren Halbleiterschalter der Halbbrückenschaltung ansteuert. Gleiches gilt auch für den oberen Halbleiterschalter.

Weiterhin sind zumindest die Schnittstellenschaltung, die Schnittstellen-Levelshifter, die Ansteuerlogik ein unterer Ansteuer-Levelshifter sowie die damit untere Treiberstufe in einem HVIC monolithisch integriert. Besonders vorteilhaft ist es wenn alle Ansteuer-Levelshifter und alle Treiberstufen monolithisch integriert sind.

Vorteilhaft ist hierbei, wenn die Halbbrückenschaltung als Zwei- oder Drei-Level Inverter ausgebildet ist. Hierbei ist es weiterhin bevorzugt, wenn ein unterer Halbleiterschalter mit dem negativen Spannungsanschluss und ein oberer Halbleiterschalter mit dem positiven Spannungsanschluss der Halbbrückenschaltung verbunden ist.

Bevorzugt ist weiterhin, wenn ein Halbleiterschalter ausgebildet ist aus mindestens einem Leistungstransistor, insbesondere einem IGBT mit antiparallel geschalteter Freilaufdiode. Hierbei stellt das Potential des Emitter das Bezugspotential des jeweiligen IGBTs dar.

Es kann weiterhin bevorzugt sein, wenn je Halbleiterschalter ein Schnittstellen-Levelshifter vorliegt.

Es kann auch vorteilhaft sein, wenn mindestens ein Schnittstellen-Levelshifter und/oder ein Ansteuer-Levelshifter dazu ausgebildet ist ein zugeordnetes Signal unidirektional zu übertragen oder dazu ausgebildet ist ein Signal und ein zugeordnetes Rücksignal zu übertragen und somit eine bidirektionale Übertragung bereitzustellen. Dazu kann mindestens ein Schnittstellen-Levelshifter und/oder ein Ansteuer-Levelshifter aus einer Mehrzahl von Teillevelshiftern ausgebildet sein, die jeweils ein Signal oder ein Rücksignal unidirektional übertragen.

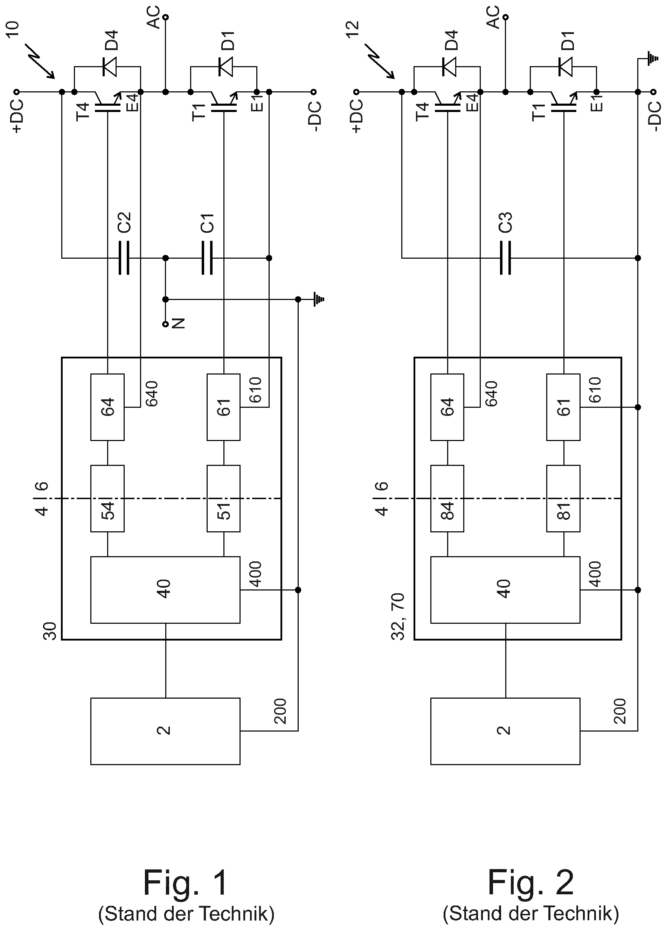

Es versteht sich, dass die verschiedenen Ausgestaltungen der Erfindung einzeln oder in beliebigen sich nicht per se ausschließenden Kombinationen realisiert sein können, um Verbesserungen zu erreichen. Weitere Erläuterung der Erfindung, vorteilhafte Einzelheiten und Merkmale, ergeben sich aus der nachfolgenden Beschreibung der in den Fig. 1 bis 5 dargestellten Ausführungsbeispiele der erfindungsgemäßen Anordnung oder von Teilen hiervon.
Fig. 1 zeigt ein Ansteuersystem mit galvanischer Trennung nach dem Stand der Technik für Halbbrückenschaltungen mit symmetrisch geerdetem Zwischenkreis.
Fig. 2 zeigt ein monolithisch integriertes Ansteuersystem nach dem Stand der Technik für Halbbrückenschaltungen mit asymmetrisch geerdetem Zwischenkreis.
Fig. 3 zeigt ein erstes erfindungsgemäßes Ansteuersystem für Zwei-Level-Inverter mit symmetrisch geerdetem Zwischenkreis.
Fig. 4 zeigt ein zweites erfindungsgemäßes Ansteuersystem für Zwei-Level-Inverter mit symmetrisch geerdetem Zwischenkreis.
Fig. 5 zeigt ein drittes erfindungsgemäßes Ansteuersystem für Drei-Level-Inverter mit symmetrisch geerdetem Zwischenkreis.

Fig. 1 zeigt ein Blockschaltbild eines Ansteuersystems mit einer Ansteuerschaltung mit galvanischer Trennung nach dem Stand der Technik, sowie eine hierdurch ansteuerbare Halbbrückenschaltung 10 mit symmetrisch geerdetem Zwischenkreis mit zwei Zwischenkreiskondensatoren C1, C2, mit einem positiven Spannungsanschluss +DC und einem negativem Spannungsanschluss -DC. Die gemeinsame Verbindung der Zwischenkreiskondensatoren C1, C2, der Neutralknoten N, ist hierbei geerdet. Diese Halbbrückenschaltung 10 weist einen, unteren sog. BOT- und einen oberen sog. TOP- Halbleiterschalter auf, die hier jeweils als ein IGBT T1, T4 mit antiparallel geschalteter Diode D1, D4 ausgebildet sind. Der BOT- Halbleiterschalter und damit der BOT IGBT T1 liegt auf dem Potential des negativen Spannungsanschlusses -DC, der TOP - Halbleiterschalter und damit der TOP IGBT T4 liegt auf dem Potential des Wechselspannungsanschlusses AC der Halbbrückenschaltung.

Die Ansteuerschaltung 30 weist einen primärseitigen Schaltungsteil 4 mit einer Ansteuerlogik 40 auf, die wie eine übergeordnete Ansteuerung 2 auf Erdpotential liegt. Weiterhin weist die Ansteuerschaltung 30 Potentialtrennglieder 51, 54 zur galvanischen Trennung zwischen dem primärseitigen 4 und den sekundärseitigen Schaltungsteilen 6 insbesondere den Treiberschaltungen 61, 64 auf. Die Bezugspotentiale 610, 640 der Treiberschaltungen 61, 64 sind mit den EmitternE1, E4 der zugeordneten IGBTs T1, T4 verbunden. Die Potentialtrennglieder 51, 54 selbst sind ausgebildet als Impulsübertrager, Optokoppler oder Lichtwellenleiter nach dem Stand der Technik.

Fig. 2 zeigt ein Blockschaltbild eines Ansteuersystems mit einer auf einem HVIC 70 monolithisch integrierten Ansteuerschaltung 32, die nach dem Stand der Technik ausgebildet ist, sowie eine hierdurch ansteuerbare Halbbrückenschaltung 12 mit asymmetrisch geerdetem Zwischenkreis und einem Zwischenkreiskondensator C3, der mit dem positiven Spannungsanschluss +DC und dem negativen und geerdeten Spannungsanschluss -DC verbunden ist. Diese Halbbrückenschaltung 12 ist im Übrigen grundsätzlich gleich derjenigen gemäß Fig. 1 aufgebaut.

Die Ansteuerschaltung 32 ist ebenfalls analog derjenigen gemäß Fig. 1 aufgebaut, allerdings sind hier die Potentialtrennglieder mit galvanischer Trennung durch Ansteuer-Levelshifter ersetzt. Der obere Ansteuer-Levelshifter 84 muss hier eine hohe Potentialdifferenz in Höhe von maximal +DC gegen Erde überwinden und ist als High Voltage (HV)-Levelshifter ausgebildet, während der untere Ansteuer-Levelshifter 81 keine oder nur eine kleine Potentialdifferenz von einigen Volt überwinden muss und daher als Medium Voltage (MV)-Levelshifter ausgebildet ist.

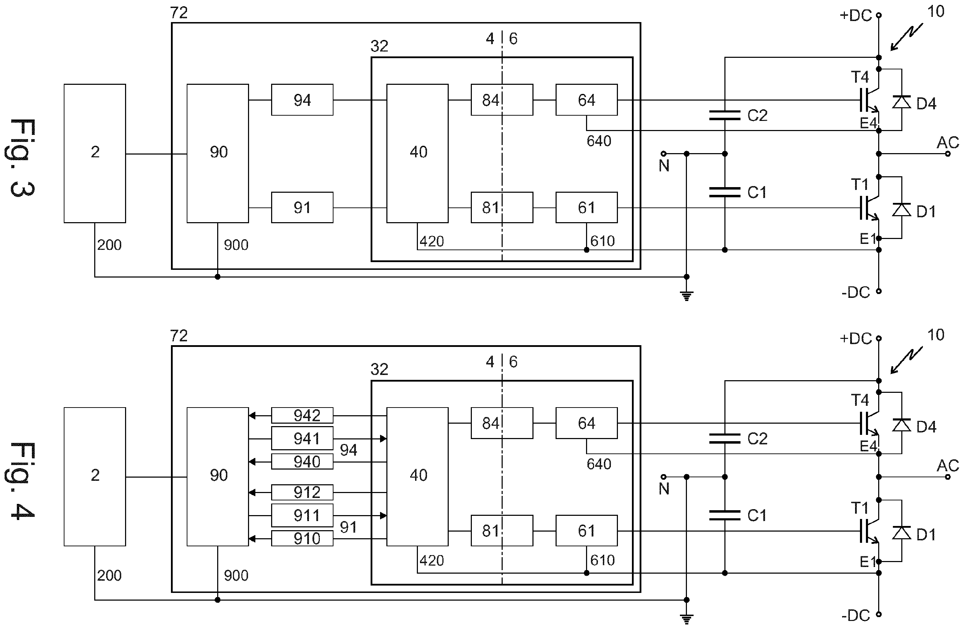

Fig. 3 zeigt ein Blockschaltbild eines erfindungsgemäßen Ansteuersystems sowie eine hierdurch ansteuerbare Halbbrückenschaltung 10, ausgebildet als Zwei-Level-Inverter, mit symmetrisch geerdetem Zwischenkreis. Das Ansteuersystem besteht aus einer übergeordneten Steuerung 2, sowie monolithisch in einem HVIC 72 integriert einer Schnittstellenschaltung 90, zwei Schnittstellen-Levelshifter 91, 94 und einer Ansteuerschaltung, die ihrerseits die gleichen Komponenten aufweist wie diejenige gemäß Fig. 2.

Die übergeordnete Steuerung 2 ist mit der Schnittstellenschaltung 90 und diese mittels eines unteren und eines oberen Schnittstellen-Levelshifters 91, 94 mit der Ansteuerschaltung 32 verbunden, wobei das Bezugspotential 900 der Schnittstellenschaltung 90 und das Bezugspotential 200 der übergeordneten Steuerung 2 mit dem geerdetem Neutralknoten N des symmetrisch geerdeten Zwischenkreises verbunden sind. Die primärseitige Teilschaltung 4, insbesondere die Ansteuerlogik 40 der Ansteuerschaltung 32, liegt auf dem Potential des negativen Spannungsanschlusses -DC der Halbbrückenschaltung 10. Das Grundpotential 610, 640 der Treiberschaltungen 61, 64 ist mit dem jeweiligen Emitter E1, E4 der zugeordneten IGBTs T1, T4 und damit mit deren Bezugspotential verbunden.

Die von der übergeordneten Steuerung 2 erzeugten Steuersignale zur Ansteuerung der Halbleiterschalter der Halbbrückenschaltung 10 werden von der Schnittstellenschaltung 90 erfasst und von den Schnittstellen-Levelshiftern 91, 94 zum primärseitigen Schaltungsteil 4, hier der Ansteuerlogik 40, der Ansteuerschaltung 32 übertragen. Die Ansteuersignale werden dort aufbereitet und über die Ansteuer-Levelshifter 81, 84 zu den zugeordneten Treiberschaltungen 61, 64 des sekundärseitigen Schaltungsteils 6 übertragen, dort verstärkt und dem jeweiligen IGBT T1, T4 zugeführt. Das Bezugspotential 610 der unteren Treiberschaltung 61 ist dabei das Potential am Emitter E1 des unteren IGBTs T1. Das Bezugspotential 640 der oberen Treiberschaltung 64 ist dabei das Potential am Emitter E4 des oberen IGBTs T4.

Die Potentialdifferenz zwischen dem Bezugspotential 200 der übergeordneten Schaltung 2 und der Schnittstellenschaltung 90 und damit auch am Neutralknoten einerseits und andererseits dem Bezugspotential der Ansteuerlogik 40 des primärseitigen Schaltungsteils 4 sowie der unteren Treiberstufe 61 des sekundärseitigen Schaltungsteils 6 und damit auch der negativen Spannungsanschlusses -DC entspricht der Potentialdifferenz des unteren Teilzwischenkreises mit dem unteren Zwischenkreiskondensator C1. Folglich muss die Spannungsfestigkeit der Schnittstellen-Levelshifter 91, 94 und die Isolation gegen Erdpotential zwischen der hierauf liegenden Schnittstellenschaltung 90, der Ansteuerlogik 40 und der unteren Treiberstufe 61 größer sein als die maximale Spannung die am unteren Zwischenkreiskondensator C1 anliegen kann. Die Übertragung der Ansteuersignale über die Schnittstellen-Levelshifter 91, 94 erfolgt hier unipolar vom Potential des Neutralpunkts N zum Bezugspotential des unteren Spannungsanschlusses -DC. Hierfür wird ein lateraler Hochspannungs- MOSFET vom p-Kanal-Typ oder ein Hochspannungskondensator eingesetzt.

Die Übertragung der Ansteuersignale von der Ansteuerlogik 40 zu den Treiberstufen 61, 64 erfolgt ebenfalls unipolar. Die hierfür notwendigen Ansteuer-Levelshifter entsprechen denjenigen gemäß Fig. 2.

Fig.4 zeigt eine zweite Ausführungsform des erfindungsgemäßen Ansteuersystems. Gegenüber der Ausgestaltung gemäß Fig. 3 werden hier bidirektionale Ansteuer-Levelshifter 91, 94, bestehend aus mehreren Teillevelshiftern 910, 911, 912, 940, 941, 942 eingesetzt. Diese Teillevelshifter übertragen Signale jeweils unidirektional, wodurch zusätzlich Hilfssignale von der Ansteuerlogik 40 zur Schnittstellenschaltung 90 übertragen werden können. Diese Hilfssignale können beispielhaft Statussignale oder Sensorsignale sein. Somit ist in der Summe eine bidirektionale Kommunikation zwischen der Schnittstellenschaltung 90 einerseits und der Ansteuerlogik 40 andererseits ausgebildet.

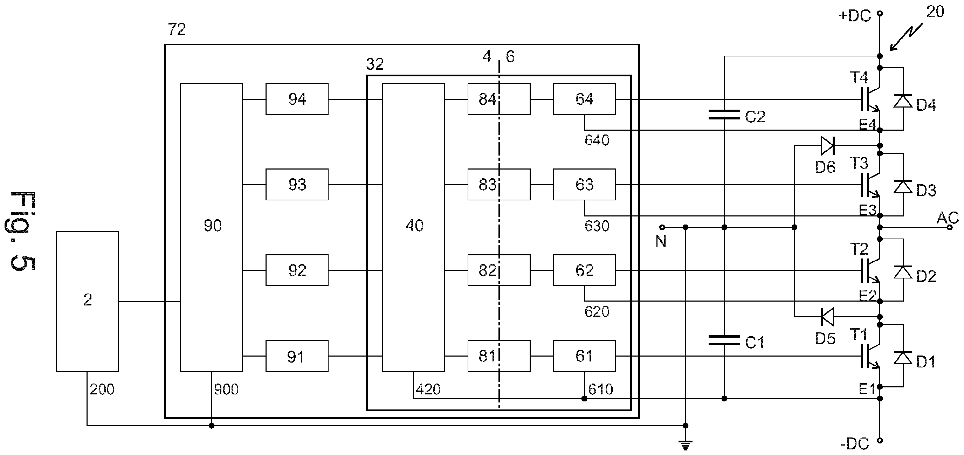

Das erfindungsgemäße Ansteuersystem kann auch für andere Halbbrückenschaltungen mit symmetrisch geerdetem Zwischenkreis, beispielhaft Drei-Level-Inverter, eingesetzt werden. Eine derartige Ausführungsform ist in Fig. 5 gezeigt.

Der hier dargestellte Drei-Level-Inverter 20 besteht aus der Reihenschaltung von vier anzusteuernden Halbleiterschaltern, jeweils ausgebildet als vier IGBTs T1 bis T4 mit dazugehörigen Freilaufdioden D1 bis D4 sowie mit zwei Begrenzungsdioden D5, D6. Der Drei-Level-Inverter 20 weist einen symmetrisch geerdeten Zwischenkreis mit zwei Zwischenkreiskondensatoren C1, C2 mit geerdetem Neutralpunkt N sowie einen positiven Spannungsanschluss +DC und einen negativem Spannungsanschluss -DC auf. Die obere Begrenzungsdiode D6 begrenzt die Spannung am Emitter E3 des dritten IGBT T3 und damit auch die Spannung am Wechselspannungsanschluss AC derart, dass sie nur Werte zwischen denjenigen des Neutralknotens N und des positiven Spannungsanschlusses +DC annehmen kann. Die untere Begrenzungsdiode D5 begrenzt die Spannung am Emitter E2 des zweiten IGBT T2 und damit auch die Spannung am Wechselspannungsanschluss AC derart, dass sie nur Werte zwischen dem unteren Spannungsanschluss -DC und dem Neutralknoten N annehmen kann. Aufgrund dieser Begrenzung von Spannungen am Neutralknoten N bezeichnet man diese Topologie als NPC (Neutral Point Clamped) Topologie.

Zur Ansteuerung des Drei-Level-Inverters 20 in NPC-Topologie wurde die Ausgestaltung des Ansteuersystems gemäß Fig. 3 derart erweitert, dass einerseits zwei weitere Schnittstellen-Levelshifter 92, 93 zwischen der Schnittstellenschaltung 90 und der Ansteuerlogik 40 angeordnet wurden. Andererseits wurde die Ansteuerschaltung 32 um zwei weitere Ansteuer-Levelshifter 82, 83 sowie um zwei weitere Treiberstufen 62, 63 mit zugeordneten Bezugspotentialen 620, 630 erweitert. Hierbei wurden selbstverständlich die Komponenten, wie die Schnittstellenschaltung 90 und die Ansteuerlogik 40 entsprechend modifiziert. Die neu hinzugekommen jeweiligen zweiten und dritten Levelshifter sind zwischen dem jeweiligen untere und oberen Levelshifter gemäß Fig. 3 angeordnet und dienen der Ansteuerung der zweiten und dritten Transistoren T2, T3, die zwischen dem unteren und oberen Transistor T1, T4 des Drei-Level-Inverters 20 angeordnet sind.

Dieses Ansteuersystem kann grundsätzlich auch für Drei-Level-Inverter in TNPC-Topologie verwendet werden.

## Patentansprüche

1. Ansteuersystem für eine Halbbrückenschaltung mit einer übergeordneten Steuerung (2), einer Schnittstellenschaltung (90) und einer Ansteuerschaltung (32) mit einem primärseitigen Schaltungsteil (4), einer Ansteuerlogik (40) mit einem primärseitigen Bezugspotential (420) und sekundärseitigen Schaltungsteilen (6) jeweils mit einer Treiberstufe (61, 62, 63, 64) ausgebildet zur Ansteuerung einer Halbbrückenschaltung (10, 20) mit einem symmetrisch an einem Neutralpunkt (N) geerdeten Zwischenkreis, einem negativen und einem positiven Spannungsanschluss (-DC, +DC), einer Mehrzahl von Halbleiterschaltern (T1, D1, T2, D2, T3, D3, T4, D4), wobei jeder Halbleiterschalter und die ihm zugeordnete Treiberstufe (61, 62, 63, 64) ein zugeordnetes sekundärseitiges Bezugspotential (610, 620, 630, 640) aufweist, wobei jeweils ein Ansteuer-Levelshifter (81, 82, 83, 84) den primärseitigen Schaltungsteil (4) mit dem jeweiligen sekundärseitigen Schaltungsteil (6) verbindet und somit jeweils beiden Schaltungsteilen zugeordnet ist und hierbei das primärseitige Bezugspotential (420) und ein unteres sekundärseitiges Bezugspotential (610) einer unteren Treiberstufe (61) dem Potential des negativen Spannungsanschlusses (-DC) entspricht,
wobei Schnittstellen-Levelshifter (91, 92, 93, 94) die Schnittstellenschaltung (90) mit der Ansteuerlogik (40) der Ansteuerschaltung (32) verbinden und hierbei die übergeordnete Steuerung (2) und die Schnittstellenschaltung (90) auf dem Potential des Neutralpunkts (N) liegen und
wobei die Schnittstellenschaltung (90), die Schnittstellen-Levelshifter (91, 92, 93, 94), die Ansteuerlogik (40) ein untere Ansteuer-Levelshifter (81) sowie die damit verbundene untere Treiberstufe (61) in einem HVIC (72) monolithisch integriert sind.

2. Ansteuerschaltung nach Anspruch 1, wobei
die Halbbrückenschaltung (10, 20) als Zwei- oder Drei-Level Inverter ausgebildet ist.

3. Ansteuerschaltung nach Anspruch 2, wobei
bei Vorliegen eines Drei-Level Inverters ein unterer Halbleiterschalter (T1, D1) mit dem negativen Spannungsanschluss (-DC) und ein oberer Halbleiterschalter (T4, D4) mit dem positiven Spannungsanschluss (+DC) des Drei-Level-Inverters verbunden ist.

4. Ansteuerschaltung nach einem der vorhergehenden Ansprüche, wobei
ein Halbleiterschalter ausgebildet ist aus mindestens einem Leistungstransistor (T1, T2, T3, T4), insbesondere einem IGBT mit antiparallel geschalteter Freilaufdiode (D1, D2, D3, D4).

5. Ansteuerschaltung nach Anspruch 4, wobei
das Potential des Emitter (E1, E2, E3, E4) das Bezugspotential des jeweiligen IGBTs (T1, T2, T3, T4) darstellt.

6. Ansteuerschaltung nach einem der vorhergehenden Ansprüche, wobei
je Halbleiterschalter ein Schnittstellen-Levelshifter (91, 92, 93, 94) vorliegt.

7. Ansteuerschaltung nach einem der vorhergehenden Ansprüche, wobei
alle Ansteuer-Levelshifter (81, 82, 83, 84) und alle Treiberstufen (61, 62, 63, 64) monolithisch integriert sind.

8. Ansteuerschaltung nach einem der vorhergehenden Ansprüche, wobei mindestens ein Schnittstellen-Levelshifter (91, 92, 93, 94) und/oder ein Ansteuer-Levelshifter (81, 82, 83, 84) dazu ausgebildet ist ein zugeordnetes Signal unidirektional zu übertragen oder dazu ausgebildet ist ein Signal und ein zugeordnetes Rücksignal zu übertragen und somit eine bidirektionale Übertragung bereitzustellen.

9. Ansteuerschaltung nach einem der vorhergehenden Ansprüche, wobei mindestens ein Schnittstellen-Levelshifter (91, 92, 93, 94) aus einer Mehrzahl von Teillevelshiftern (910, 911, 912, 940, 941, 942) ausgebildet ist die jeweils ein Signal oder ein Rücksignal jeweils unidirektional übertragen.

## Claims

1. Actuating system for a half-bridge circuit with a superordinate controller (2), an interface circuit (90) and an actuating circuit (32) with a primary-side circuit part (4), an actuating logic circuit (40) with a primary-side reference potential (420) and secondary-side circuit parts (6) in each case having a driver stage (61, 62, 63, 64) designed for actuating a half-bridge circuit (10, 20) with an intermediate circuit which is earthed symmetrically at a neutral point (N), a negative and a positive voltage connection (-DC, +DC), a plurality of semiconductor switches (T1, D1, T2, D2, T3, D3, T4, D4), wherein each semiconductor switch and the driver stage (61, 62, 63, 64) assigned to said semiconductor switch have an assigned secondary-side reference potential (610, 620, 630, 640), wherein in each case an actuating level shifter (81, 82, 83, 84) connects the primary-side circuit part (4) to the respective secondary-side circuit part (6) and thus in each case is assigned to both circuit parts and, in this connection, the primary-side reference potential (420) and a lower secondary-side reference potential (610) of a lower driver stage (61) correspond to the potential of the negative voltage connection (-DC),
wherein interface level shifters (91, 92, 93, 94) connect the interface circuit (90) to the actuating logic circuit (40) of the actuating circuit (32) and, in this connection, the superordinate controller (2) and the interface circuit (90) are at the potential of the neutral point (N) and
wherein the interface circuit (90), the interface level shifters (91, 92, 93, 94), the actuating logic circuit (40), a lower actuating level shifter (81) and the lower driver stage (61) connected to said lower actuating level shifter are monolithically integrated in an HVIC (72).

2. Actuating circuit according to Claim 1, wherein the half-bridge circuit (10, 20) is designed as a two-level or three-level inverter.

3. Actuating circuit according to Claim 2, wherein, when there is a three-level inverter, a lower semiconductor switch (T1, D1) is connected to the negative voltage connection (-DC) and an upper semiconductor switch (T4, D4) is connected to the positive voltage connection (+DC) of the three-level inverter.

4. Actuating circuit according to any of the preceding claims, wherein
a semiconductor switch is formed from at least one power transistor (T1, T2, T3, T4), in particular an IGBT with freewheeling diode (D1, D2, D3, D4) connected back-to-back in parallel.

5. Actuating circuit according to Claim 4, wherein the potential of the emitter (E1, E2, E3, E4) is the reference potential of the respective IGBT (T1, T2, T3, T4).

6. Actuating circuit according to any of the preceding claims, wherein
one interface level shifter (91, 92, 93, 94) is present per semiconductor switch.

7. Actuating circuit according to any of the preceding claims, wherein
all of the actuating level shifters (81, 82, 83, 84) and all of the driver stages (61, 62, 63, 64) are monolithically integrated.

8. Actuating circuit according to any of the preceding claims, wherein
at least one interface level shifter (91, 92, 93, 94) and/or one actuating level shifter (81, 82, 83, 84) is designed to transmit an assigned signal in a unidirectional manner or is designed to transmit a signal and an assigned reverse signal and thus to provide bidirectional transmission.

9. Actuating circuit according to any of the preceding claims, wherein
at least one interface level shifter (91, 92, 93, 94) is formed from a plurality of partial level shifters (910, 911, 912, 940, 941, 942) which in each case transmit a signal or a reverse signal in a unidirectional manner in each case.

## Revendications

1. Système de commande pour un circuit à demi-pont avec une commande prioritaire (2), un circuit d'interface (90) et un commutateur de commande (32) avec une partie de circuit primaire (4), une logique de commande (40) avec un potentiel de référence primaire (420) et des parties de circuit secondaires (6) respectivement avec un étage pilote (61, 62, 63, 64) constitué pour commander un circuit à demi-pont (10, 20) avec un circuit intermédiaire mis à la terre symétriquement à un point neutre (N), une connexion de tension négative et une connexion de tension positive (-CC, +CC), une pluralité de commutateurs à semi-conducteurs (T1, D1, T2, D2, T3, D3, T4, D4), chaque commutateur à semi-conducteurs et l'étage pilote qui lui est attribué (61, 62, 63, 64) comportant un potentiel de référence secondaire attribué (610, 620, 630, 640), un compensateur de niveau de commande (81, 82, 83, 84) reliant la partie de circuit primaire (4) à la partie de circuit secondaire respective (6) et étant ainsi respectivement attribué aux deux parties de circuit et à cet effet le potentiel de référence primaire (420) et un potentiel de référence secondaire inférieur (610) d'un étage pilote inférieur (61) correspondant au potentiel de la connexion de tension négative (-CC), les compensateurs de niveau d'interface (91, 92, 93, 94) reliant le circuit d'interface (90) à la logique de commande (40) du circuit de commande (32) et la commande prioritaire (2) et le circuit d'interface (90) se trouvant à cet effet sur le potentiel du point neutre (N) et le circuit d'interface (90), les compensateurs de niveau d'interface (91, 92, 93, 94), la logique de commande (40), un compensateur de niveau de commande (81) ainsi que l'étage pilote inférieur (61) qui y est relié étant intégrés de manière monolithique dans un circuit intégré à haute tension (CIHT)(72).

2. Commutateur de commande selon la revendication 1, le circuit à demi-pont (10, 20) étant constitué comme un onduleur à deux ou trois niveaux.

3. Commutateur de commande selon la revendication 2, en présence d'un onduleur à deux ou trois niveaux, un commutateur à semi-conducteurs (T1, D1) inférieur étant relié à la connexion de tension négative (-CC) et un commutateur à semi-conducteurs supérieur (T4, D4) étant relié à la connexion de tension positive (+CC) de l'ondulateur à trois niveaux.

4. Commutateur de commande selon l'une quelconque des revendications précédentes, un commutateur à semi-conducteurs étant constitué à partir d'au moins un transistor de puissance (T1, T2, T3, T4), notamment un transistor bipolaire à grille isolée (IGBT) avec diode de marche à vide (D1, D2, D3, D4) connectée de façon antiparallèle.

5. Commutateur de commande selon la revendication 4, le potentiel de l'émetteur (E1, E2, E3, E4) représentant le potentiel de référence du transistor bipolaire à grille isolée (IGBT) respectif (T1, T2, T3, T4).

6. Commutateur de commande selon l'une quelconque des revendications précédentes, chaque commutateur à semi-conducteurs disposant d'un compensateur de niveau d'interface (91, 92, 93, 94).

7. Commutateur de commande selon l'une quelconque des revendications précédentes, tous les compensateurs de niveau de commande (81, 82, 83, 84) et tous les étages pilotes (61, 62, 63, 64) étant intégrés de manière monolithique.

8. Commutateur de commande selon l'une quelconque des revendications précédentes, au moins un compensateur de niveau d'interface (91, 92, 93, 94) et/ou un compensateur de niveau de commande (81, 82, 83, 84) étant constitués pour transmettre de manière unidirectionnelle un signal attribué ou étant constitué pour transmettre un signal et un signal de retour attribué et fournir ainsi une transmission bidirectionnelle.

9. Commutateur de commande selon l'une quelconque des revendications précédentes, au moins un compensateur de niveau d'interface (91, 92, 93, 94) étant constitué d'une pluralité de compensateurs de niveau partiels (910, 911, 912, 940, 941, 942) qui transmettent respectivement un signal ou un signal de retour de manière respectivement unidirectionnelle.
